# EUROPEAN PATENT APPLICATION

(11) **EP 1 696 253 A2**
(43) Date of publication of application: **30.08.2006**
(21) Application number: 06075246.6
(22) Date of filing: 01.02.2006
(51) Int. Cl.: G02B 7/00, H01L 21/60

(54) **Accurate relative alignment and epoxy-free attachment of optical elements**

(30) Priority: 24.02.2005 US 87171
(71) Applicant: Northorp Grumman Corporation, Los Angeles, CA 90067 (US)
(72) Inventor: Bosco, Nicholas S., Hermosa Beach, California 90254 (US)
(74) Representative: Martin, Philip John

(57) **Abstract**

A method for accurately positioning and aligning multiple components, such as optical components, on a common substrate. A separate pattern of solder bumps is formed on the substrate for each of the components to be mounted. Congruent patterns of solder pads are formed on the respective components. The components are placed and positioned on the substrate as accurately as possible using manual or other means, and then the assembly,is heated sufficiently to reflow the solder bumps beneath each component. During reflow, the solder pads on the domponents move into accurate alignment with the solder bumps on the substrate. On cooling, the components are attached and remain in the automatically aligned configuration.

## Description

### BACKGROUND OF THE INVENTION

This invention relates generally to techniques for affixing and aligning components on a common substrate and, more particularly, to techniques for accurate alignment of optical components on a common substrate. Fabrication, of optoelectronic modules presents a significantly greater challenge than fabrication of semiconductor modules, the fundamental difference being the need to achieve and maintain a high accuracy in alignment between optical and optoelectronic components.

Traditional methods of aligning optical components require the labor-intensive step of real-time active measurement to ensure component alignment prior to and during attachment, typically using an optical adhesive. Optical adhesives were originally two-part epoxies formulated to optimize their properties of adhesion and strength. These materials have been further refined for use in applications involving precise alignment, positioning and centering applications. Use of adhesives in such applications has been facilitated by the cure-on-demand characteristic of ultraviolet (UV) curable materials. Such adhesives, however, are not suitable for bonding components in hermetic packages containing laser diodes. This is because laser diodes are subject to a mechanism of catastrophic optical damage (COD) in which organic compounds contained in the adhesive contaminate the emitting facet of the diode, ultimately leading to failure. Solders requiring flux lead to the same mechanism of COD as organic adhesives, and therefore should also be avoided in the packaging of devices that include laser diodes.

It will be appreciated from the foregoing that there is still a need for improvement in the techniques used to affix and align components, such as optical components, on a common substrate since both adhesives and solders that require flux both pose significant problems. While the use of fluxless solder avoids the problems relating to the before mentioned mechanism of COD, there is still a need for an alignment technique that does not require the use of costly and labor intensive real-time measurement techniques. The present invention satisfies this need.

### SUMMARY OF THE INVENTION

The present invention resides in a novel process for accurate alignment and attachment of components on a common substrate, using a fluxless, self-aligning bump-bonding technique. Briefly, and in general terms, the method of the invention may be defined as including the steps of applying to a surface of each component to be attached to the substrate, a plurality of metal pads, the plurality of pads being arranged in a selected pattern; applying to a surface of the substrate, a plurality of patterns of solder bumps, each pattern of solder bumps being congruent with a corresponding pattern of metal pads on a component. The succeeding steps of the method include placing each component on the substrate with the pattern of metal pads on the component in near-congruence with the corresponding pattern on the substrate; then heating the substrate and the components and thereby reflowing the solder bumps. As a result of reflowing the solder bumps, each component is automatically aligned on the substrate. Each component is allowed to move laterally and rotationally to align the corresponding patterns of solder bumps and metal pads. Upon cooling of the substrate and the components, the solder bumps return to the solid state, and the components remain accurately aligned in their desired positions on the substrate.

To facilitate initial positioning of each component on the substrate, the pattern of metal pads on the component and the corresponding pattern of solder bumps on the substrate each include a distinctively shaped pad and solder bump, respectively. For example, each pattern may include one pad (or bump) of square cross section, as easily distinguished from the other pads and bumps of circular cross section.

The step of applying solder bumps to the substrate comprises applying a photoresist layer to the substrate; photolithographically patterning the photoresist layer to form in the layer openings that define the pattern of solder bumps in position and dimensions; depositing solder on the substrate, to form the solder bumps on the substrate; and then removing the photoresist layer. The step of applying solder bumps to the substrate may further comprise the steps of applying a metal layer to the substrate before applying the photoresist layer; and later removing portions of the metal layer not contained beneath the solder bumps, after the photoresist layer has been removed. The metal serves as an adhesion layer for the solder.

In a presently preferred embodiment of the invention, the solder is a gold-tin (Au-Sn) solder in the ratio 80/20 and the substrate is of copper-tungsten (CuW). In this embodiment, the metal layer is nickel (Ni) and the metal layer is later removed by chemical etching.

The step of applying a plurality of metal pads to each component comprises forming multiple successive metal layers on the component; lithographically patterning the metal layers; and then removing unwanted materials from the structure. In one embodiment of the invention, the multiple metal layers are applied first, then patterned with a photoresist layer to define the desired metal pads. Then the removing step includes etching away the unwanted portions of the metal layer and removing the photoresist layer. In an alternate embodiment of the invention, the patterning step is performed first, to define pad areas by openings in a photoresist layer; and the step of forming successive metal layers applies metal through the openings in the photoresist layer. Finally, the removing step removes the photoresist layer, to leave the metal pads in the desired pattern.

To facilitate the positioning of the photolithographic pattern, and therefore metal pads, on a component, each pattern further comprises at least one reference line corresponding with a geometric feature of the component. In an illustrative embodiment of the invention, the photolithographic pattern includes a pair of lines at right-angies, corresponding to the position of a right-angle edge of the component, such as a right-angle prism.

The step of forming multiple successive metal layers on a glass component comprises the steps of, first, applying a titanium layer to serve as an adhesion layer for a component of glass; next applying a Ni layer over the titanium, to serve as a diffusion barrier; and then applying a gold layer over the Ni layer, to serve as a wetting layer for the solder.

It will be appreciated from the foregoing summary that the present invention represents a significant advance in the field of accurate affixing and alignment of components, such as optical components on a common substrate. In particular, the invention results in accurate positioning and alignment of components without the need for real-time alignment steps and without using optical adhesives or solder requiring flux. Other aspects and advantages of the invention will become apparent from the following more detailed description, taken in conjunction with the accompanying claims.

### BRIEF DESCRIPTION OF THE DRAWINGS

FIGS. 1A-1C together depict the phenomenon of self-alignment employed in the method of the present invention.

FIG. 2 is a gold-tin equilibrium phase diagram.

FIG. 3 is a schematic view of a submount bumping pattern.

FIG. 4 is a schematic view of an optical component alignment pattern and a depiction of how that pattern is aligned with respect to a component (prism).

FIGS. 5A-5D together show a process for forming a pattern of solder bumps on a submount.

FIGS. 6A-6D together show a process for forming a pattern of solder pads on a submount or substrate.

FIGS. 7A-7C together show an alternate process for forming a pattern of solder pads on a submount.

FIG. 8 is a schematic view of a bumping pattern for an optical component, and also showing a pair of right-angle lines used for alignment of the pattern on a component (prism).

### DETAILED DESCRIPTION OF THE INVENTON

As shown in the drawings for purposes of illustration, the present invention is concerned with methods for affixing and aligning components with great accuracy on a common substrate. Prior to the present invention, alignment was achieved only by means of real-time active measurement during attachment using an organic adhesive.

In accordance with the present invention, components, such as optical prisms, are affixed to and accurately aligned on a substrate or optical submount using a self-aligning soldering technique. The technique can be implemented by the deposition of solder bumps on the substrate and pads on each component. Active measurement during assembly is not required because component alignment is guaranteed within the geometry of the bump spacing or pitch, and is further guaranteed through a self-alignment phenomenon that arises from the tendency of molten solder to form a shape that minimizes surface energy and therefore surface area.

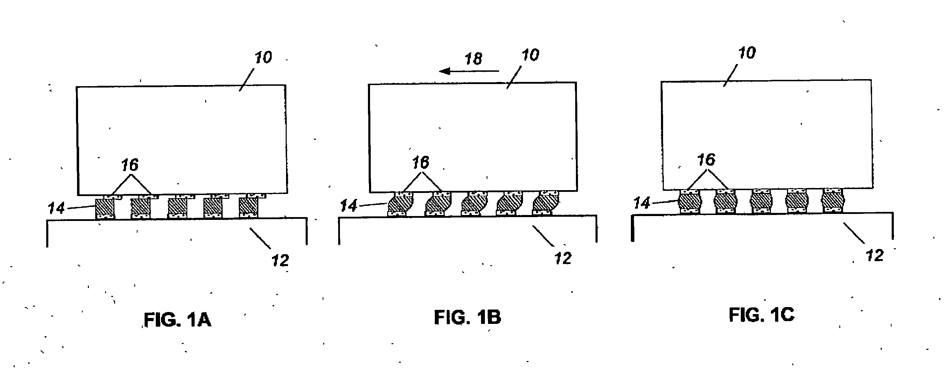

FIGS. 1A, 1B and 1C together depict in diagrammatic form the self-alignment phenomenon that is a critical aspect of the present invention. As shown in FIG. 1A, an optical component 10, shown as a prism by way of example, is initially placed over a submount 12 with some degree of misalignment. In this description, and in the claims that follow, the terms "submount" and "substrate" are used synonymously. As will be discussed below in more detail, the submount 12 has formed on its upper surface a pattern of solder bumps 14. The prism 10 has on its underside an identically spaced pattern of solder pads 16. It will be understood, however, that for some applications of the invention the locations of the solder bumps 14 and solder pads 16 may be reversed.

When the prism 10 is initially positioned over the submount 12 as accurately as possible, using, for example, an optical microscope and manual positioning, inevitably there is some degree of misalignment of the patterns of solder bumps 14 and solder pads 16. In FIG. 1A, this misalignment is shown as being along an axis parallel to the planar interface between the prism 10 and submount 12. In practice, of course, the misalignment may be in either or both of two orthogonal directions (x and y) in this planar interface, and may also include a rotational misalignment about a third axis '(z) perpendicular to the x and y axes. It is assumed that any dimensional misalignment along the z axis and any rotational misalignment along the x or y axis can be effectively eliminated if the thicknesses of the solder bumps14 and pads 16 are uniform over the extent of the bump and pad patterns.

FIG. 1B illustrates the same structure as FIG. 1A but at the beginning of a solder reflow step, in which the solder bumps 14 are heated sufflciently for the solder to enter the liquid phase. Because of the tendency of each of the solder bumps 14 to minimize its surface area, the bumps assume a near spherical in shape, and in doing so apply an alignment force on the solder pads 16, as indicated by the arrow 18. For the solder bumps 14 to reach a symmetrical near-spherical form, the solder pads 16, and with them the prism 10, are translated laterally to the fully aligned position shown in FIG. 1C. It will be understood that, depending on the nature of the initial misalignment, the reflow step may also result in a component of alignment force along the other of the x and y axes and, if necessary, a rotational self-alignment torque.

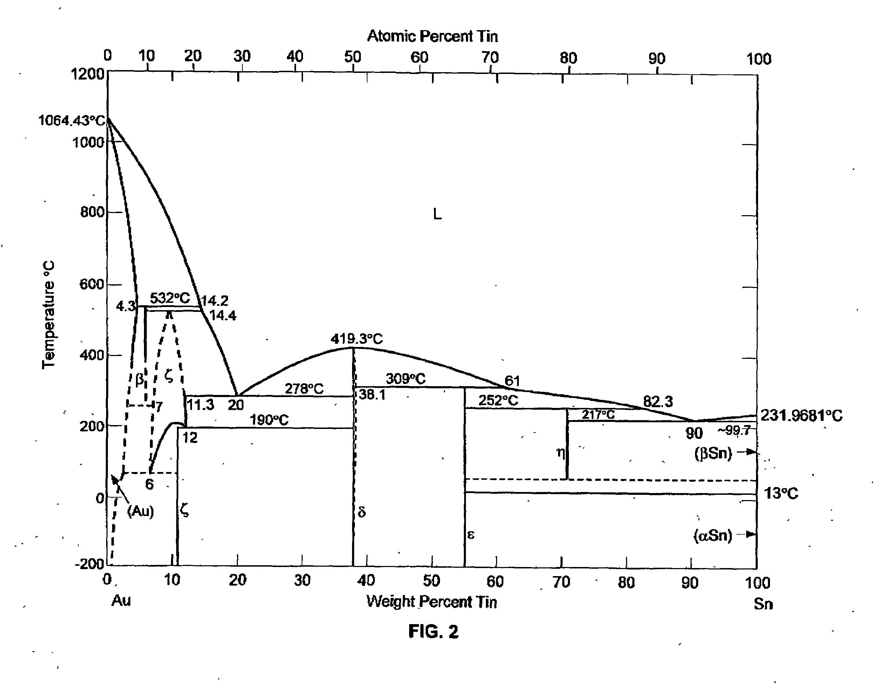

In a presently preferred embodiment of the present invention, bonding is effected using eutectic Au-Sn (80/20) metallurgy. This system is desirable for use in a photonics package because it offers the advantages of good mechanical properties, low melting temperature, and fluxless reflow, which precludes contamination of optically active surfaces. The Au-Sn equilibrium phase diagram is shown in FIG. 2. It shows that there are six intermetallic phases, four of which are stable at ambient conditions, and the two solid solutions. The solder alloy at 20 wt% Sn is chosen for its eutectic composition, which, upon cooling the molten alloy through the eutectic temperature of 278 °C, solidifies to form a eutectic structure of the Au₅Sn and AuSn phases. A more detailed discussion of the Au-Sn metallurgy can be found in a paper by Song, H.G., Ahn, J.P., and Morris, Jr., J.W., "The microstructure of eutectic Au-Sn solder bumps on Cu/ electroless Ni/Au", J. of Electronic Materials, 30 [9] 2001.

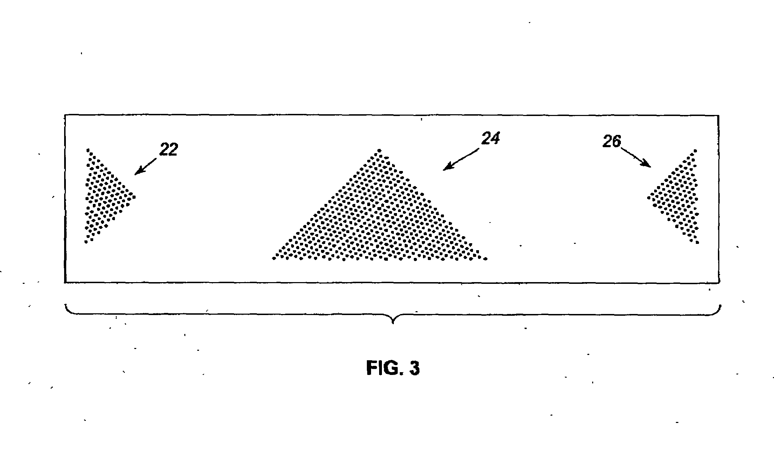

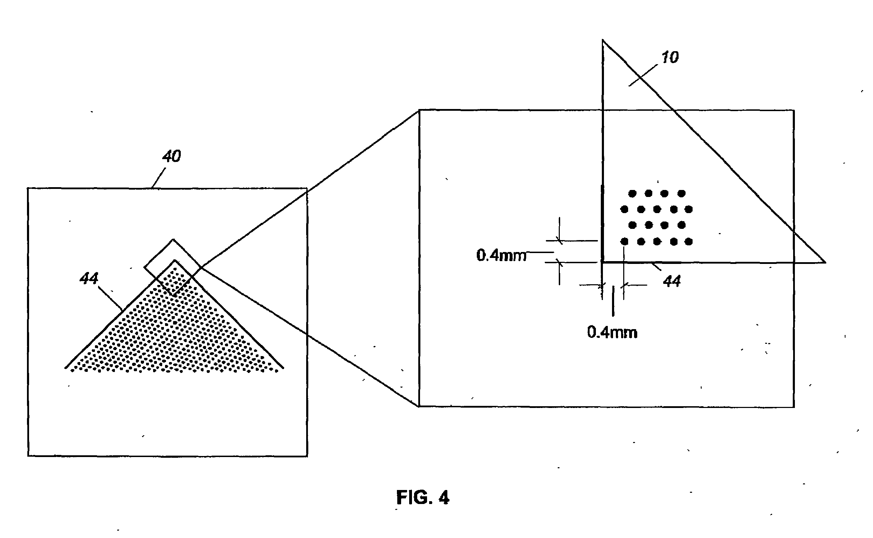

The technique of the invention as used to align multiple components on a single submount is diagrammatically illustrated in FIGS. 3 and 4. FIG. 3 depicts a pattern 20 for a submount 12, with three alignment patterns 22, 24 and 26 formed as part of it. To achieve accurate relative alignment of the three corresponding components, such as prisms, the three submount alignment patterns 22, 24 and 26 are all formed as a single pattern 20 that accurately reflects the positioning and alignment of the three components. To ensure alignment of each component on the submount, the component alignment pattern 40includes pairs of lines at right angles to each other 44, or at some other angle if the prisms being mounted and aligned are not right prisms. As described below with reference to FIG. 4, these right-angle lines facilitate the placement of the alignment pattern on the prism, and therefore the alignment of the prisms on the submount. The off-set of these pairs of lines from the component alignment pattern creates congruency between the submount alignment pattern, the component alignment pattern, and the desired feature of the component to be aligned, such as the reflecting surface of a prism.

FIG. 4 depicts a critical alignment step in forming a' pattern on a component such as a prism 10. A prism alignment pattern 40 is formed to define a triangular array that will be used to define the positions of solder pads, and a pair of lines 44 at right-angles to each other. As indicated in the figure, prior to forming the solder pads on the prism 10, the pattern 40 is aligned over the prism such that the roof angle of the prism is aligned with the pair of lines 44. Then the process of forming the solder pads is performed, as described in more detail below.

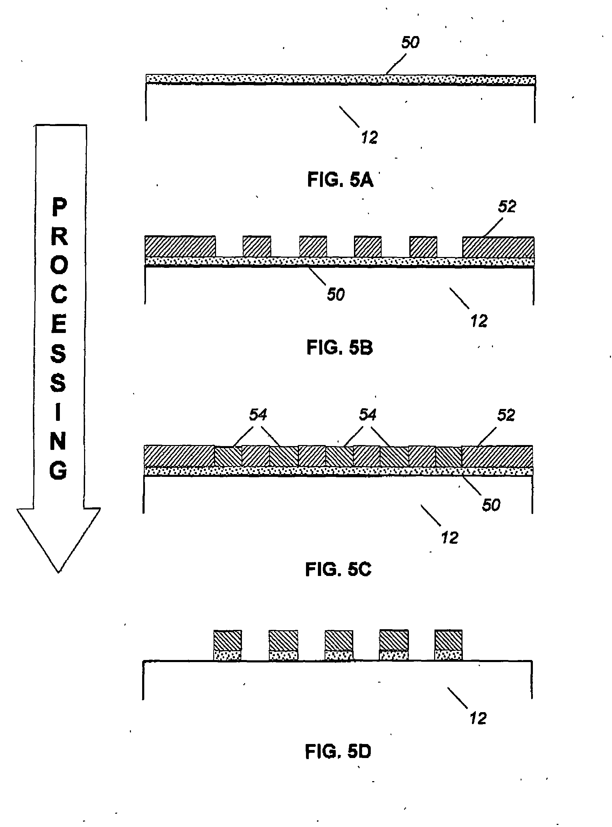

Processing of the submount 12 to form a pattern of solder bumps 14 on its surface is depicted in FIGS. 5A-5D. As shown in FIG. 5A, a layer of Ni 50 is first applied to the submount 12, which, in the preferred embodiment of the invention is of a copper-tungsten (CuW) alloy. The Ni layer 50 may be conveniently formed by electroplating, with a thickness of approximately 2.5 µm. The Ni layer 50 serves as an adhesion layer and forms the under-bump metallurgy (UBM) for the later applied (Au-Sn) solder. The Ni barrier layer 50 results in formation of an intermetallic interface of Ni₃Sn₂ that forms the connection between the solder and Ni. The growth of this layer has been studied and found to be relatively slow, following a rate proportional to the square root of time, suggesting its diffusion-limited growth. Furthermore, growth of this phase has not been found to decrease the strength of the resulting joints.

Next, as shown in FIG. 5B, the electroplated parts are masked by applying a photoresist layer 52 that is subsequently structured in a photolithographic step, which defines the positions of the solder bumps as openings in the photoresist layer 52. The negatively masked sub-mounts are then electroplated with approximately 30 µm of solder alloy, (80/20 Au-Sn), as indicated at 54 in FIG. 5C. The photomask 52 is subsequently removed by an acetone soak, revealing the desired array of solder bumps 14, as depicted in FIG. 5D. Finally, the electroplated Ni layer 50 is removed by means of a chemical etch (FeCl₃), revealing the original CuW surface between the solder bumps 14. This step is taken to ensure a non-wetting condition between the solder bumps 14 and substrate. The composition and thickness of the evaporated bumps are confirmed by energy dispersive spectroscopy (EDS) and profilometry, respectively.

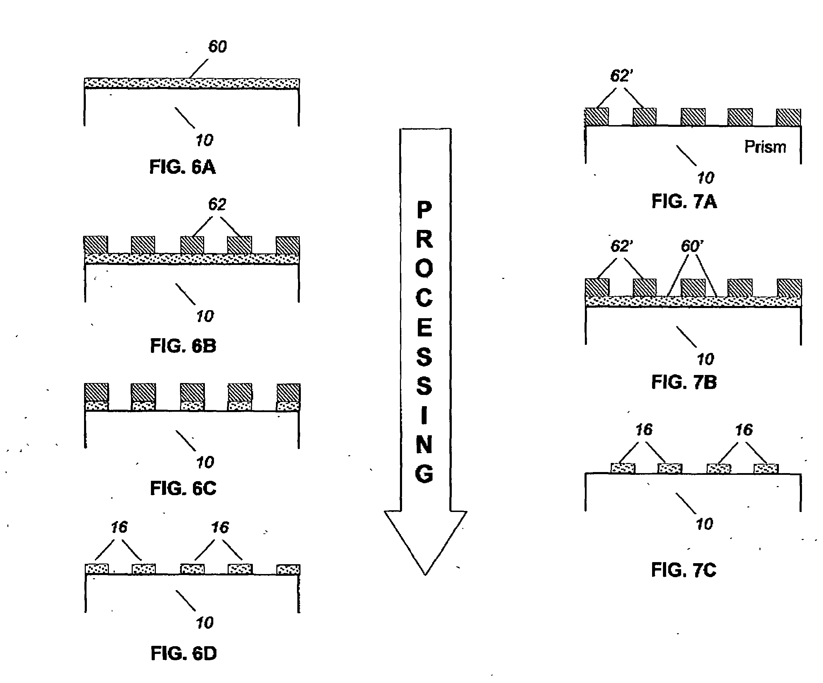

FIGS. 6A-6D show the processing steps used to form a pattern of solder pads 16 on an optical component 10, such as a prism. The solder pads 16 were developed on prisms of BK7 glass, which has a comparable coefficient of thermal expansion to the CuW material chosen for the submount 12. The pad metallurgy consists of a first layer (200 nm thick) of titanium (Ti), followed by a second layer (1000 nm thick) of Ni, and a third layer (300 nm) of Au. These layers, indicated collectively by reference numeral 60, are deposited on the prism 10 using a single gun four-source electron-beam deposition (EBD) system. The Ti serves as an adhesion layer to the glass, the Ni provides a diffusion barrier, and Au serves as a wetting layer for the solder. Deleterious effects of oxidation of the metal surfaces can be minimized by keeping the samples in the evaporation chamber between depositions of the various layers, and minimizing the intervening times. In a photolithographic step, as indicated in FIG. 6B, a resist layer 62 is applied over the evaporated metal layers 60 and is patterned to define the positions of the solder pads 16. Once the positive pattern in the resist layer 62 has been developed on the prism, the exposed Au, Ni, and Ti layers 60 are removed through a three-stage chemical etch with aqueous solutions of K+Kl, FeCl₃, and HF/HNO₃ respectively. The remaining portions of the photoresist 62 are finally removed with an acetone soak, revealing a corresponding array of pads 16 to the solder bumps developed on the sub-mounts.

FIGS. 7A-7C illustrate an alternative to the pattern etching process of FIGS. 6A-6D. In the alternate method, the photolithography step and the evaporation steps are reversed. Thus, FIG. 7A shows an initial photolithography step, in which a resist layer 62' is first formed, then patterned to leave openings that defined the positions of the solder pads 16. Next, as shown in FIG. 7B, the layers of Ti, Ni and Au are evaporated into the regions exposed by the photolithography step of FIG. 7A. Finally, the resist layer 60' is removed by a lift-off step, leaving, as shown in FIG. 7C, the pattern of solder pads 16.

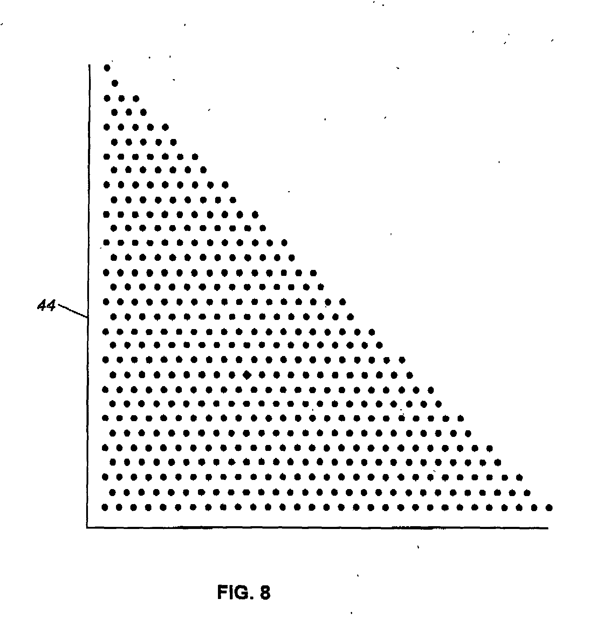

The design of the prism alignment pattern is shown in FIG. 8. The pattern consists of an array of 130 µm diameter circles at a spacing, or pitch, of 290 µm. To aid with alignment, each pattern has a corresponding circular pad replaced with a square. By matching the square pad over the square bump, overall pattern orientation is insured. This scheme was chosen with a goal of optimizing the self-alignment phenomenon and overall joint strength. Prior to solder reflow and self-alignment, the geometry of the pattern dictates that the corresponding component and sub-mount patterns cannot be offset greater than 130 µm in translation (Δx, Δy) or 0.86° in rotation (θ_{z}), provided rough alignment appropriately places the patterns. The other three degrees of freedom, (Δz, θₓ, and θ_{y}) are dictated by the bonding height, which is dependent on the uniformity in solder bump and pad thickness. Due to the method of solder and pad deposition along with the characteristics of the bonding technique, the overall bond thickness is expected to be extremely uniform, thereby ensuring accurate alignment in these latter three degrees of freedom.

The two right-angle legs of the prism are used as a positional reference and thus the photomask was created with two right-angle lines (shown at 70 in FIG. 8) to orient the pattern to the prism. Under magnification in a Kasper/ Myraid mask aligner, the prism is translated and rotated until the insides of the right-angle lines 70 are aligned with the outsides of the right angle legs of the prism. Once aligned, the pattern is exposed and developed. When designing the submount photomask for the alignment of multiple components, the orientation of the pad pattern to the right angle lines, or prism legs, are referenced.

Rough alignment of the prism to the sub-mount is achieved by exploiting the transparency of the prism. With the aid of a stereomicroscope, the bottom surface of the prism may be imaged by focusing through the glass. This brings the solder bumps 16 and pads 14 into view simultaneously, allowing for their rough alignment through delicate manual manipulation of the prism. It is foreseeable that this step may be automated, conducted by currently developed pick-and-place devices widely used in the electronics industry.

Bonding is conducted in a processing chamber (not shown) that uses a graphite stage as the resistive heating element. A unique feature of this chamber is a removable glass cover that allows for alignment of the components on the heating stage, mitigating the necessity to move the assembly after rough alignment has been made. The transparency of this cover also makes it possible to view the instant of solder reflow and the self-alignment phenomenon. Bonding, including solder reflow and self-alignment of the components 10 on the submount 12, is achieved under a constant flow of hydrogen gas with a heating rate of approximately 140° K/ min with a 1-minute dwell at 315 °C.

It will be appreciated from the foregoing that the present invention provides a novel process of aligning components on a submount to a high level of accuracy. In particular, optical components, which must be positioned and aligned to a high degree of accuracy, may be positioned and aligned on a submount without the need for labor-intensive real-time alignment steps and without using optical adhesives. It will also be appreciated that, although the invention has been described in detail for purposes of illustration, various modifications may be made without departing from the spirit and scope of the invention. Accordingly, the invention should not be limited except as by the appended claims.

## Claims

1. A method for alignment and attachment of multiple components on a common substrate, comprising:
applying, to a surface of each component to be attached to the substrate, a plurality of metal pads, the plurality of pads being arranged in a selected pattern;
applying, to a surface of the substrate, a plurality of patterns of solder bumps, each pattern of solder bumps being congruent with a corresponding pattern of metal pads on a component;
placing each component on the substrate with the pattern of metal pads on the component in congruence with the corresponding pattern on the substrate;
heating the substrate and the components, thereby reflowing the solder bumps;
as a result of the reflowing of the solder bumps, automatically aligning each component on the substrate, wherein each component is allowed to move laterally and rotationally to align the corresponding patterns of solder bumps and metal pads; and
allowing the substrate and the components to cool and the solder bumps to return to a solid state, accurately attaching the components to the substrate in their desired positions.

2. A method as defined in claim 1, wherein the selected pattern of metal pads on each component, and the corresponding pattern of solder bumps on the substrate, Include a distinctively shaped pad and solder bump, respectively, to facilitate initial alignment of each component on the substrate.

3. A method as defined in claim 2, wherein the distinctively shaped pad and solder bump is of square cross section, to distinguish visually from a circular cross section of all of the other pads and bumps.

4. A method as defined in claim 1, wherein each pattern for solder pads further comprises at least one reference line corresponding with an edge of the component, to facilitate initial positioning and alignment of the pattern on the component.

5. A method as defined in claim 4, wherein the at least one reference line is a pair of lines at right-angles, corresponding to the position of a right-angle edge of the component.

6. A method as defined in claim 1, wherein the step of applying solder bumps to the substrate comprises:
applying a photoresist layer to the substrate;
photolithographically patterning the photoresist layer to form openings in the layer that define the patterns of solder bumps in position and dimensions;
depositing solder on the substrate, to form the solder bumps on the substrate; and
removing the photoresist layer.

7. A method as defined in claim 6, wherein the step of applying solder bumps to the substrate further comprises:
before applying the photoresist layer, applying a metal layer to substrate; and
after removing the photoresist layer; removing portions of the metal layer not contained beneath the solder bumps;
wherein the metal layer serves as an adhesion layer for the solder.

8. A method as defined in claim 7, wherein:
the solder is a gold-tin solder in the ratio 80/20;
removal of the photoresist layer is effected by soaking in acetone;
the substrate is of copper-tungsten (CuW);
the metal layer is nickel; and
the metal layer is removed by chemically etching.

9. A method as defined in claim 1, wherein the step of applying a plurality of metal pads to each component comprises:
forming multiple successive metal layers on the component;
lithographically patterning the metal layers; and
removing unwanted materials from the structure.

10. A method as defined in claim 9, wherein:
the multiple metal layers are applied first, then patterned with a photoresist layer to define the desired metal pads; and
the removing step includes etching the unwanted portions of the metal layer and removing the photoresist layer.

11. A method as defined in claim 9, wherein:
the patterning step is performed first, to define pad areas by openings in a photoresist layer;
the step of forming successive metal layers applies metal through the openings in the photoresist layer; and
the removing removes the photoresist layer, to leave the metal pads in the desired pattern.

12. A method as defined claim 9, wherein the step of forming multiple successive metal layers comprises:
first applying a titanium layer to serve as an adhesion layer for component of glass;
next applying a nickel layer to serve as a diffusion barrier; and
then applying a gold layer to serve as a wetting layer for the solder.

13. A method for alignment and attachment of multiple optical components on a common substrate, comprising:
applying, to a glass surface of each optical component to be attached to the substrate, a plurality of metal pads, the plurality of pads being arranged in a selected pattern;
applying, to a surface of the substrate, a plurality of patterns of solder bumps, each pattern of solder bumps being congruent with a corresponding pattern of metal pads on a component;
placing each optical component on the substrate with the pattern of metal pads on the component as closely as possible in congruence with the corresponding pattern on the substrate;
heating the substrate and the optical components, thereby reflowing the solder bumps;
as a result of the reflowing of the solder bumps, automatically aligning each optical component on the substrate, wherein each optical component is allowed to move laterally and rotationally to align the corresponding patterns of solder bumps and metal pads; and
allowing the substrate and the components to cool and the solder bumps to return to a solid state, accurately attaching the components to the substrate in their desired positions.

14. A method as defined in claim 13, wherein:
at least one of the optical components is a right-angle prism;
the pattern of metal pads formed on the prism is in the form of a triangular matrix, formed on a triangular face of the prism; and
at least one of the patterns of solder bumps formed on the substrate is also triangular.

15. A method as defined in claim 12, wherein the step of applying solder bumps to the substrate comprises:
applying a photoresist layer to the substrate;
photolithographically patterning the photoresist layer to form openings in the layer that define the patterns of solder bumps in position and dimensions;
depositing solder on the substrate, to form the solder bumps on the substrate; and
removing the photoresist layer.

16. A method as defined in claim 15, wherein the step of applying solder bumps to the substrate further comprises:
before applying the photoresist layer, applying a metal layer to substrate; and
after removing the photoresist layer, removing portions of the metal layer not contained beneath the solder bumps;
wherein the metal layer serves as an adhesion layer for the solder.

17. A method as defined in claim 16, wherein the step of applying a plurality of metal pads to each optical component comprises:
forming multiple successive metal layers on the optical component;
lithographically patterning the metal layers; and
removing unwanted materials from the structure.

18. A method as defined in claim 17, wherein:
the solder is a gold-tin solder in the ratio 80/20;
removal of the photoresist layer is effected by soaking in acetone;
the substrate is of copper-tungsten (CuW);
the metal layer is nickel; and
the metal layer is removed by chemically etching.

19. A method as defined in claim 17, wherein:
the multiple metal layers are applied first, then patterned with a photoresist layer to define the desired metal pads; and
the removing step includes etching the unwanted portions of the metal layer and removing the photoresist layer.

20. A method as defined in claim 17, wherein:
the patterning step is performed first, to define pad areas by openings in a photoresist layer;
the step of forming successive metal layers applies metal through the openings in the photoresist layer; and
the removing removes the photoresist layer, to leave the metal pads in the desired pattern.

21. A method as defined claim 17, wherein the step of forming multiple successive metal layers comprises:
first applying a titanium layer to serve as an adhesion layer for a glass optical component;
next applying a nickel layer to serve as a diffusion barrier; and
then applying a gold layer to serve as a wetting layer for the solder.
